(19) Europäisches Patentamt
European Patent Office
Office européen des brevets

(11) **EP 2 614 379 B1**

(12) **FASCICULE DE BREVET EUROPEEN**

(45) Date de publication et mention de la délivrance du brevet:
**16.04.2014 Bulletin 2014/16**

(51) Int Cl.:
*G01R 31/11* *(2006.01)*      *G01R 31/02* *(2006.01)*

(21) Numéro de dépôt: **11752559.2**

(86) Numéro de dépôt international:
**PCT/EP2011/065568**

(22) Date de dépôt: **08.09.2011**

(87) Numéro de publication internationale:
**WO 2012/032125 (15.03.2012 Gazette 2012/11)**

(54) **PROCEDE ET DISPOSITIF DE MESURE DES CARACTERISTIQUES PHYSIQUES D'UN CABLE, EN PARTICULIER DE LA VITESSE DE PROPAGATION**

VERFAHREN UND VORRICHTUNG ZUR MESSUNG DER PHYSIKALISCHEN EIGENSCHAFTEN EINES KABELS, IM BESONDEREN DER AUSBREITUNGSGESCHWINDIGKEIT

METHOD AND DEVICE FOR MEASURING PHYSICAL CHARACTERISTICS OF A CABLE, IN PARTICULAR THE PROPAGATION VELOCITY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.09.2010  FR 1057189**

(43) Date de publication de la demande:
**17.07.2013  Bulletin 2013/29**

(73) Titulaire: **Commissariat à l'Énergie Atomique et aux Énergies Alternatives 75015 Paris (FR)**

(72) Inventeurs:
• **SOMMERVOGEL, Laurent**
  **F-78350 Jouy-en-Josas (FR)**
• **COHEN, Josy**
  **F-94420 Le Plessis Trevise (FR)**

(74) Mandataire: **Hammes, Pierre et al**
  **Marks & Clerk France**
  **Immeuble Visium**
  **22, avenue Aristide Briand**
  **94117 Arcueil Cedex (FR)**

(56) Documents cités:
**DE-C- 947 497        DE-C1- 19 839 677**
**JP-A- 63 193 077     US-A- 3 753 086**
**US-A- 3 991 364**

**Description**

L'invention concerne un procédé et un dispositif de mesure des caractéristiques physiques d'un câble. Elle concerne en premier lieu la mesure de la vitesse de propagation sur un câble mais également la détermination de sa longueur et de l'atténuation d'une onde électromagnétique se propageant dans un tel câble.

L'invention s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible de générer, à un endroit quelconque du câble une singularité mesurable.

Une singularité dans un câble correspond à une rupture des conditions de propagation du signal dans ce câble. Elle résulte le plus souvent d'un défaut qui impacte localement l'impédance caractéristique du câble en provoquant une discontinuité dans ses paramètres linéiques.

Pour caractériser un câble électrique, il est important de connaître la vitesse de propagation d'un signal dans ce câble. En particulier, une mesure précise de cette vitesse est nécessaire lorsque l'on cherche à diagnostiquer des défauts sur un câble. La détection de défauts se fait, de façon connue, en injectant un signal haute fréquence qui se propage le long du câble et se réfléchit sur chacune de ses singularités. A partir de la connaissance du retard entre les diverses réflexions, la localisation précise des défauts peut être effectuée. Cependant, pour passer d'une information de durée à une information de distance, il est nécessaire de connaitre précisément la vitesse de propagation du signal. La mesure de cette vitesse doit être possible à tout instant afin notamment de prendre en compte ses variations au cours du temps liées au vieillissement du câble, ou à une modification des contraintes mécaniques qui peuvent s'exercer sur lui telles qu'une traction une torsion ou encore un enroulement.

On connaît des solutions de détermination de la vitesse de propagation par des modèles mathématiques et/ou physiques et une estimation des paramètres primaires du câble. Ces solutions ont pour défaut d'être imprécises et surtout de ne pas prendre en compte le vieillissement du câble et l'évolution de la vitesse au cours du temps.

D'autres méthodes, appelées méthodes de réflectométrie, utilisent des instruments coûteux, volumineux et non embarquables, ce qui présente également le défaut de ne pas permettre l'actualisation des mesures au cours de la vie du câble.

La demande de brevet américaine US 2010/0045968 décrit une méthode alternative permettant une mesure non intrusive de la vitesse de propagation dans un câble ainsi que de sa longueur à partir de faisceaux optiques projetés dans la direction transverse du câble et analysés par deux capteurs optiques.

On connait également le document US 3991364 qui décrit une méthode de localisation d'un défaut électrique dans un câble, cependant ce document ne concerne pas la mesure de caractéristiques physiques d'un câble.

On connait également le document DE 947497C qui décrit une méthode basée sur l'utilisation de singularités artificielles mais ne vise pas non plus la détermination de caractéristiques physiques d'un câble.

La présente invention a pour but de permettre la mesure de la vitesse de propagation d'un câble par une méthode non intrusive et adaptée au suivi de l'évolution de la vitesse au cours du temps. L'invention a également pour objectif de mettre en oeuvre un dispositif qui présente un encombrement limité en vue d'être utilisé dans des applications mobiles. Enfin l'invention a également pour but la mesure de paramètres caractéristiques d'un câble électrique tels que sa longueur et l'atténuation d'un signal se propageant dans ce câble.

A cet effet l'invention a pour objet un procédé de mesure des caractéristiques physiques d'un câble caractérisé en ce qu'il comporte au moins les étapes suivantes :

     ○ le positionnement sur ledit câble de moyens de création d'une singularité artificielle,
     ○ l'injection, en un point dudit câble, d'un signal électrique de test,
     ○ l'acquisition dudit signal réfléchi sur les singularités que comporte ledit câble de façon à produire un premier réflectogramme,
     ○ la mesure, sur ledit réflectogramme, de la position temporelle $\Delta t$ du pic du signal issu de sa réflexion sur ladite singularité artificielle,
     ○ la détermination de la vitesse de propagation $v_p$ = $2x/\Delta t$ du signal dans ledit câble à partir de la position temporelle $\Delta t$ et de la position x desdits moyens de création d'une singularité artificielle sur le câble.

Dans une variante de réalisation de l'invention, la position temporelle $\Delta t$ est mesurée par rapport au premier pic temporel du réflectogramme et la position x est mesurée par rapport au point d'injection.

Dans une variante de réalisation, le procédé selon l'invention comporte en outre les étapes suivantes :

     ○ le décalage desdits moyens de création d'une singularité artificielle d'une distance d sur le câble,
     ○ une seconde injection dudit signal électrique de test audit point d'injection,
     ○ l'acquisition dudit signal réfléchi sur les singularités que comporte ledit câble de façon à produire un deuxième réflectogramme,
     ○ la soustraction desdits premier et deuxième réflectogrammes afin de produire un troisième réflectogramme,

la position temporelle Δt étant mesurée entre les deux pics d'amplitude les plus élevées du troisième réflectogramme et la position x étant prise égale à d.

Dans une variante de réalisation de l'invention, les moyens de création d'une singularité artificielle sont constitués au moins d'un des éléments suivants : un anneau métallique, une boucle ferromagnétique, une goulotte serre-câble ou une bague constituée, dans le sens longitudinal, d'une alternance de métal et d'isolant.

Dans une variante de réalisation de l'invention, les réflectogrammes sont traités par un algorithme d'augmentation du rapport signal sur bruit.

Dans une variante de réalisation, l'invention comporte en outre une étape de mesure de la longueur du câble à partir de la mesure de vitesse de propagation $v_p$ et du retard Δt' entre le premier et le dernier pic de signal du premier réflectogramme.

Dans une variante de réalisation de l'invention, le signal de test injecté est une impulsion temporelle ou un signal à gabarit spectral contrôlé.

Dans une variante de réalisation, le procédé selon l'invention comporte en outre une étape de mesure de l'atténuation α du signal à travers le câble à l'aide de

la relation suivante $\alpha = -20\log\dfrac{\Gamma'}{\sqrt{1-\Gamma^2}}$, avec Γ

l'amplitude du premier pic du premier réflectogramme, associé au point d'injection du signal et Γ' l'amplitude du dernier pic du premier réflectogramme associé à l'extrémité du câble.

L'invention a également pour objet un dispositif de mesure des caractéristiques physiques d'un câble comportant au moins un dispositif d'injection d'un signal de test, un dispositif d'acquisition du signal de test réfléchi sur les singularités du câble, des moyens de création d'une singularité artificielle positionnés sur ledit câble et un dispositif de post traitement dudit signal réfléchi, ledit dispositif de mesure étant adapté à mettre en oeuvre les étapes du procédé selon l'invention.

Dans une variante de réalisation de l'invention, le dispositif d'injection et le dispositif d'acquisition sont conjointement réalisés par un générateur de forme d'onde ou un oscilloscope ou un analyseur de réseau vectoriel ou une carte électronique.

D'autres caractéristiques apparaîtront à la lecture de la description détaillée donnée à titre d'exemple et non limitative qui suit faite en regard de dessins annexés qui représentent :

La figure 1, un schéma illustrant la mise en oeuvre du procédé selon l'invention,
La figure 2, un exemple de réflectogramme obtenu dans un cas idéal, en absence de perturbations,
La figure 3, une illustration du dispositif selon l'invention,
La figure 4, un exemple de réflectogramme obtenu dans un cas réel,

La figure 5, le réflectogramme obtenu à partir de l'invention dans le cas d'une singularité générée à une distance de 17 cm du point d'injection,
La figure 6, le réflectogramme obtenu à partir de l'invention dans le cas d'une singularité générée à une distance de 51 cm du point d'injection,
La figure 7, le réflectogramme obtenu dans une variante de réalisation de l'invention.

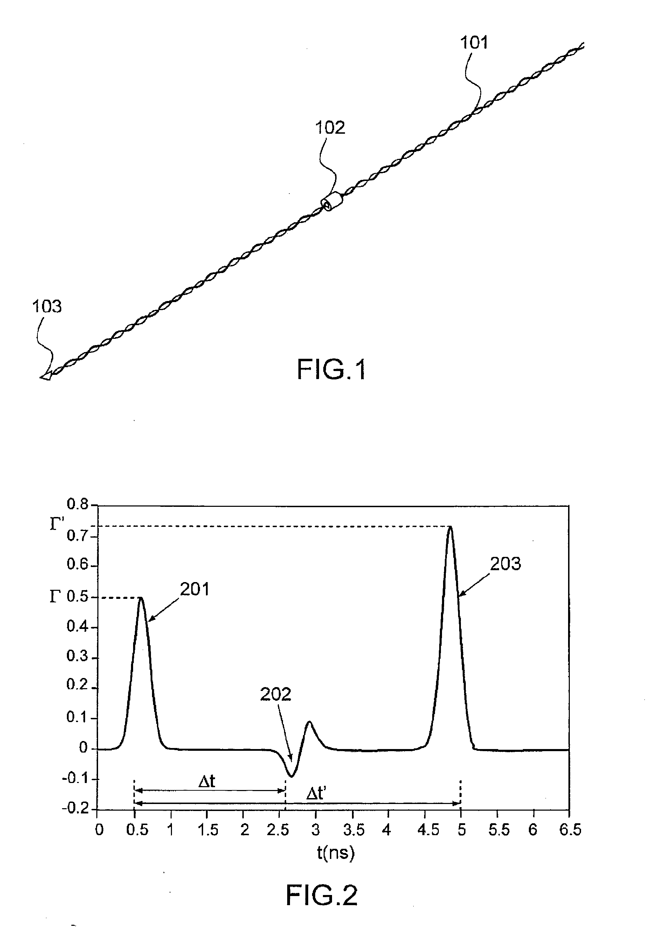

La figure 1 illustre la mise en oeuvre du procédé selon l'invention permettant de déterminer la vitesse de propagation sur un câble électrique 101. Au moins une extrémité de ce câble doit être accessible à un opérateur. Un élément 102, par exemple un anneau métallique, est positionné à un emplacement quelconque du câble dans le but de créer artificiellement une singularité. Cet élément 102 peut être, mais pas uniquement, une bague métallique, une boucle ferromagnétique, une goulotte serre-câble ou tout autre moyen permettant de modifier localement l'impédance caractéristique de la ligne constituée par le câble. L'élément 102 est externe au câble, provisoire et réversible, il est positionné sur le câble uniquement pour la mise en oeuvre du procédé selon l'invention et doit pouvoir être retiré par la suite. Le positionnement de cet élément 102 est non intrusif. Dans la suite de la description, on parlera de bague pour désigner cet élément 102. A l'extrémité 103 du câble, un signal connu est injecté par des moyens de génération et d'injection de signal dans un câble. Ils sont associés à des moyens d'acquisition du signal réfléchi sur les singularités du câble. Lesdits moyens d'acquisition sont aptes à produire un réflectogramme temporel du signal injecté. A titre d'exemple non limitatif, les dispositifs suivants peuvent être utilisés soit comme moyens d'injection, soit comme moyens d'acquisition ou encore exécutant les deux fonctions conjointement : un générateur de forme d'onde, un oscilloscope, un analyseur de réseau vectoriel ou encore une carte électronique composée de circuits intégrés de type FPGA ou DSP sur laquelle sont implémentés les traitements à exécuter. Le signal injecté est un signal haute fréquence présentant des caractéristiques connues. Il s'agit, par exemple, d'une impulsion temporelle de faible largeur. Si des contraintes liées à la compatibilité électromagnétique de l'environnement du câble existent, un signal respectant une forme d'onde à gabarit spectral contrôlé est injecté. L'onde incidente résultant de cette injection va rencontrer la bague 102 lors de sa propagation et va alors générer un écho sur le dispositif d'acquisition qui mémorise le réflectogramme temporel obtenu en conséquence. Cet écho est lié à la singularité créée par la bague 102 à une distance x du point d'injection 103. Dans une variante de réalisation de l'invention, le réflectogramme obtenu est soumis à un ou plusieurs algorithmes de nettoyage dont l'objectif est double. D'une part, un tel algorithme permet de retrouver la réponse impulsionnelle du signal injecté, d'autre part il permet également d'augmenter le rapport signal sur bruit. De tels algorithmes consistent, par exemple, en un moyennage, un filtrage adapté, un algorithme de déconvolution simple ou un algorithme itératif FISTA (« Fast Iterative Shrinkage Thresholding Algorithm »). Dans un premier mode de réalisation de l'invention, la distance x entre le point d'injection 103 et la bague 102 est connue. Dans ce cas, l'exploitation du réflectogramme obtenu par le dispositif d'acquisition permet de déterminer la vitesse de propagation $v_p$ comme l'illustre la figure 2.

Sur la figure 2 est représenté un exemple de réflectogramme selon l'invention obtenu dans un cas idéal pour lequel aucune perturbation ou bruit n'entache les mesures. Ce réflectogramme comporte un premier pic 201 qui correspond au point d'injection du signal qui est ici une impulsion temporelle. Le dernier pic 203 correspond à l'extrémité du câble. Le second pic 202 correspond à la singularité générée par la bague 102. Si la fréquence d'échantillonnage du signal est suffisamment élevée, le pic 202 peut être double. il est constitué dans ce cas d'un pic d'amplitude négative suivi d'un pic d'amplitude positive qui correspondent respectivement à la désadaptation générée par le début de la bague et celle créée par la fin de la bague qui présente une certaine largeur. Si la fréquence d'échantillonnage du signal est faible, les deux pics successifs sont confondus. Le réflectogramme obtenu permet de déterminer les retards des différentes réflexions du signal injecté sur les singularités rencontrées sur la ligne. Ainsi le retard $\Delta t$ mesuré entre le point d'injection et le second pic rencontré permet de remonter directement à la vitesse de propagation par la relation suivante

$$v_p = \frac{2x}{\Delta t}.$$

Dans un cas réel, le signal transmis le long du câble est soumis à des perturbations diverses qui peuvent engendrer des pics secondaires de bruit sur le réflectogramme. Les pics 201,202,203 contenant l'information requise doivent être identifiés et différenciés des pics secondaires de bruit. En particulier les seconds et derniers pics 202,203 sont les deux pics d'amplitude les plus élevées apparaissant sur le réflectogramme après le premier pic 201.

L'information de vitesse de propagation obtenue $v_p$ permet également d'en déduire la longueur du câble. En effet, le dernier pic mesuré 203 correspond à la réflexion du signal sur l'extrémité terminale du câble. La mesure du retard $\Delta t'$ entre le pic correspondant au point d'injection et celui associé à la fin du câble permet d'en déduire la longueur L du câble par la relation suivante:

$$L = v_p \frac{\Delta t'}{2}.$$ Enfin l'amplitude $\Gamma$ du premier pic permet également de déterminer l'impédance caractéristique $Z_c$ de la ligne à l'aide de la relation suivante :

$$Z_c = Z_0 \frac{1+\Gamma}{1-\Gamma},$$ où $Z_0$ est l'impédance de sortie du dispositif de mesure.

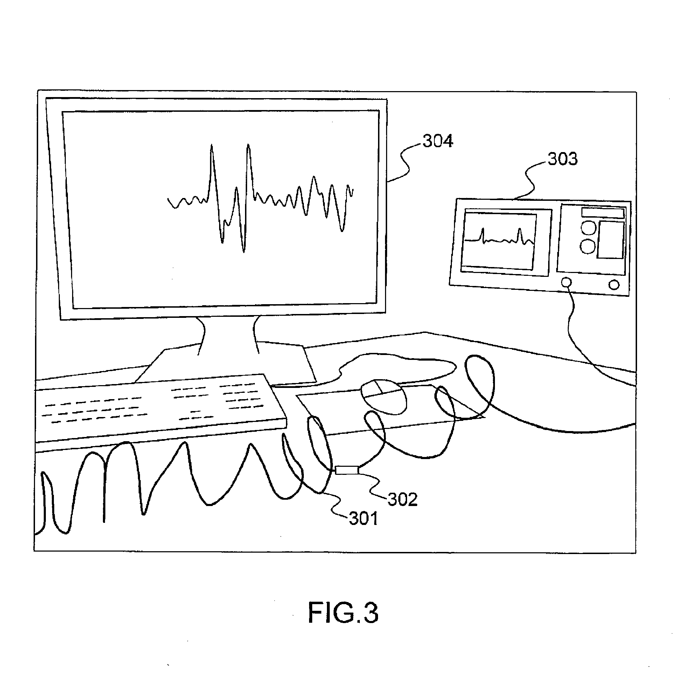

La figure 3 schématise le dispositif selon l'invention qui comporte, outre la bague 302 positionnée sur le câble 301, des moyens d'injection et d'acquisition d'un signal 303 et une unité de post traitement 304 qui réalise, à partir du ou des réflectogrammes produits par les moyens d'acquisition 303, une mesure des caractéristiques physiques du câble, notamment sa vitesse de propagation et sa longueur.

Dans une variante de réalisation de l'invention dans laquelle la distance x n'est pas connue, le procédé selon l'invention comporte les étapes supplémentaires suivantes. L'opérateur décale la bague 102 d'une distance d connue de telle sorte qu'elle soit située à la distance x+d du point d'injection. Un second réflectogramme correspondant à cette seconde singularité créée est déterminé. Les deux réflectogrammes obtenus sont soustraits afin d'une part de mesurer l'écart temporel $\Delta t''$ entre les deux pics associés aux deux positions successives de la bague et d'autre part de supprimer les pics parasites éventuellement liés à d'autres singularités non maitrisées. Enfin la vitesse de propagation est obtenue à l'aide de la relation suivante $v_p = \frac{2d}{\Delta t''}.$

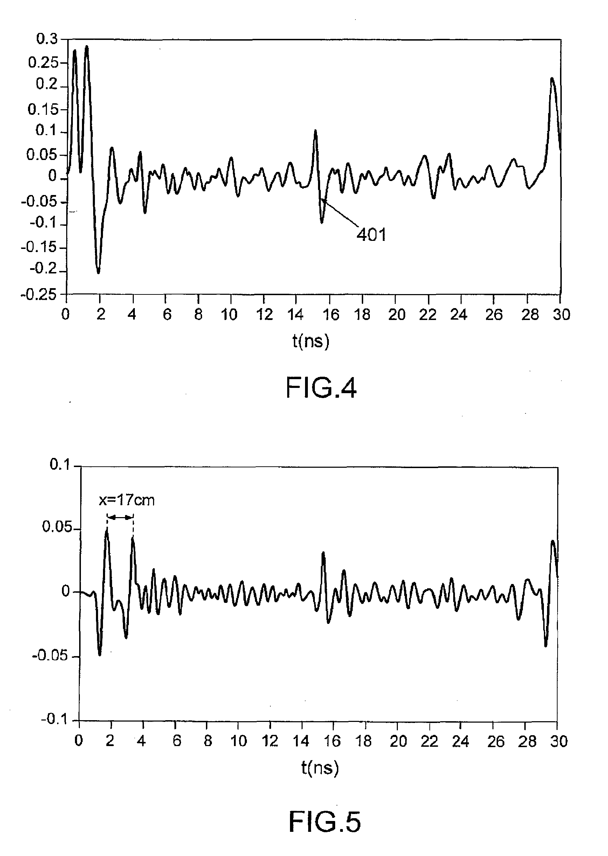

Les figures 4 à 7 illustrent la mise en oeuvre du procédé selon l'invention pour le cas de la variante de réalisation précitée. La figure 4 représente un réflectogramme de référence obtenu à partir d'une méthode de réflectométrie temporelle appliqué à un câble électrique. Par rapport au cas idéal décrit à la figure 2, ce réflectogramme comporte d'une part des perturbations de type bruit aléatoire qui créent de nombreux pics temporels mais d'amplitude faible et d'autre part un pic 401 d'amplitude plus élevée correspondant à un défaut électrique. De tels défauts peuvent perturber les mesures effectuées lorsqu'ils correspondent à des singularités générant, sur le signal réfléchi, un pic d'amplitude équivalente à celui résultant de la singularité créée artificiellement par l'introduction de la bague métallique. Dans un tel cas de figure, il devient impossible de distinguer, sur le réflectogramme temporel, les pics d'amplitude associés à des singularités non provoquées (défauts électriques) de celui induit par le positionnement d'un moyen de création artificiel d'une singularité.

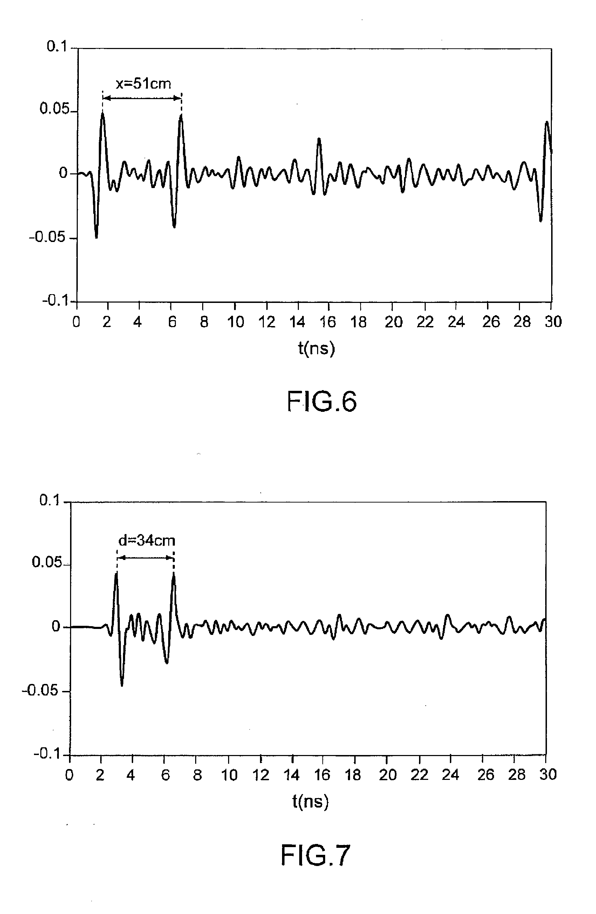

Pour pallier ce problème et éliminer les perturbations liées à un défaut impactant une zone précise du câble, il convient de soustraire le réflectogramme de référence avec celui obtenu après positionnement de la bague métallique. A titre d'exemple, la figure 5 représente le réflectogramme obtenu après soustraction du réflectogramme de référence pour une bague métallique positionnée à une distance de 17 cm du point d'injection. Dans le cas où cette distance n'est pas connue, une seconde mesure est effectuée pour laquelle la bague est déplacée, le réflectogramme obtenu est illustré à la figure 6, pour une position de la bague à 34 cm de sa position précédente et à 51 cm du point d'injection. En effectuant la soustraction des deux réflectogrammes, on obtient le résultat illustré à la figure 7 qui permet, à partir de la mesure du retard observé entre les deux premiers pics d'amplitude d'en déduire la vitesse de propagation à partir de la seule connaissance de la distance d dont la bague a été déplacée entre les deux mesures. Ainsi, la position de la bague par rapport au point d'injection du signal n'a pas besoin d'être connue. Cet avantage est important pour des câbles de longueur très élevée, par exemple des câbles réseau pour lesquels l'opérateur peut intervenir à n'importe quel endroit sans nécessairement devoir mesurer l'emplacement de la bague par rapport à l'extrémité du câble.

Dans les exemples de réalisation de l'invention décrits ci-dessus, la singularité créée par la bague métallique engendre deux pics d'amplitude successifs (un pic négatif puis un pic positif) sur le réflectogramme. Sans sortir du cadre de l'invention, les moyens de création artificielle d'une singularité peuvent provoquer des variations d'impédance locale plus complexe dans le but de produire une signature permettant d'identifier le tronçon de câble testé de manière unique et également de détecter plus facilement cette signature lorsque le rapport signal sur bruit est faible. Pour générer une telle signature, les moyens précités peuvent consister en une bague alternant, dans son sens longitudinal, métal et isolant. Dans un tel cas, la détection du second pic 202 d'amplitude relatif à la réflexion sur la singularité artificielle se fait par identification de la variation d'amplitude autour de ce pic avec la signature connue.

Dans une variante de réalisation de l'invention, le procédé porte également sur la mesure de l'atténuation du signal se propageant dans le câble. A partir de l'information $\Gamma$ donnant l'amplitude du premier pic et en mesurant l'amplitude $\Gamma'$ du dernier pic correspondant à la réflexion du signal sur la fin du câble, l'atténuation $\alpha$ en décibels subit par le signal haute fréquence lors de sa propagation entre le point d'injection et l'extrémité opposée du câble est déterminée à l'aide de la relation suivante:

$$\alpha = -20 \log \frac{\Gamma'}{\sqrt{1 - \Gamma^2}}.$$

Pour obtenir une mesure de l'atténuation du signal par unité de distance parcourue, il convient de diviser $\alpha$ par la longueur L du câble qui est aussi la distance entre le point d'injection du signal et la fin du câble.

La présente invention a pour avantage de permettre une mesure des caractéristiques d'un câble électrique de façon non intrusive. Elle permet également de suivre le vieillissement d'un câble par un suivi de la vitesse mesurée au cours du temps.

## Revendications

1. Procédé de mesure des caractéristiques physiques d'un câble (101) **caractérisé en ce qu'**il comporte au moins les étapes suivantes :

○ le positionnement sur ledit câble de moyens (102) de création d'une singularité artificielle,
○ l'injection, en un point (103) dudit câble, d'un signal électrique de test,
○ l'acquisition dudit signal réfléchi sur les singularités que comporte ledit câble de façon à produire un premier réflectogramme,
○ la mesure, sur ledit réflectogramme, de la position temporelle $\Delta t$ du pic (202) du signal issu de sa réflexion sur ladite singularité artificielle,
○ la détermination de la vitesse de propagation $v_p = 2x/\Delta t$ du signal dans ledit câble à partir de la position temporelle $\Delta t$ et de la position x desdits moyens (102) de création d'une singularité artificielle sur le câble.

2. Procédé de mesure selon la revendication 1 **caractérisé en ce que** la position temporelle $\Delta t$ est mesurée par rapport au premier pic temporel du réflectogramme et la position x est mesurée par rapport au point (103) d'injection.

3. Procédé de mesure selon la revendication 1 **caractérisé en ce qu'**il comporte en outre les étapes suivantes :

○ le décalage desdits moyens (102) de création d'une singularité artificielle d'une distance d sur le câble,
○ une seconde injection dudit signal électrique de test audit point (103) d'injection,
○ l'acquisition dudit signal réfléchi sur les singularités que comporte ledit câble de façon à produire un deuxième réflectogramme,
○ la soustraction desdits premier et deuxième réflectogrammes afin de produire un troisième réflectogramme,
la position temporelle $\Delta t$ étant mesurée entre les deux pics d'amplitude les plus élevées du troisième réflectogramme et la position x étant prise égale à d.

4. Procédé de mesure selon l'une des revendications précédentes **caractérisé en ce que** lesdits moyens (102) de création d'une singularité artificielle sont constitués au moins d'un des éléments suivants : un anneau métallique, une boucle ferromagnétique, une goulotte serre-câble ou une bague constituée, dans le sens longitudinal, d'une alternance de métal et d'isolant.

5. Procédé de mesure selon l'une des revendications précédentes **caractérisé en ce que** lesdits réflectogrammes sont traités par un algorithme d'augmentation du rapport signal sur bruit.

6. Procédé de mesure selon l'une des revendications précédentes **caractérisé en ce qu'**il comporte en outre une étape de mesure de la longueur du câble à partir de la mesure de vitesse de propagation $v_p$ et du retard $\Delta t'$ entre le premier (201) et le dernier (203) pic de signal du premier réflectogramme.

7. Procédé de mesure selon l'une des revendications précédentes **caractérisé en ce que** ledit signal de test injecté est une impulsion temporelle ou un signal à gabarit spectral contrôlé.

8. Procédé de mesure selon l'une des revendications 1 à 7 **caractérisé en ce qu'**il comporte en outre une étape de mesure de l'atténuation $\alpha$ du signal à travers le câble à l'aide de la relation suivante

$$\alpha = -20\log\frac{\Gamma'}{\sqrt{1-\Gamma'^2}},$$ avec $\Gamma$ l'amplitude du

premier pic du premier réflectogramme, associé au point d'injection du signal et $\Gamma'$ l'amplitude du dernier pic du premier réflectogramme associé à l'extrémité du câble.

9. Dispositif de mesure des caractéristiques physiques d'un câble (301) comportant au moins un dispositif d'injection (303) d'un signal de test, un dispositif d'acquisition (303) du signal de test réfléchi sur les singularités du câble, des moyens (102) de création d'une singularité artificielle positionnés sur ledit câble et un dispositif (304) de post traitement dudit signal réfléchi, ledit dispositif de mesure étant adapté à mettre en oeuvre les étapes du procédé selon l'une des revendications 1 à 8.

10. Dispositif de mesure selon la revendication 9 **caractérisé en ce que** le dispositif d'injection et le dispositif d'acquisition sont conjointement réalisés par un générateur de forme d'onde ou un oscilloscope ou un analyseur de réseau vectoriel ou une carte électronique.

**Patentansprüche**

1. Verfahren zum Messen der physikalischen Eigenschaften eines Kabels (101), **dadurch gekennzeichnet, dass** es wenigstens die folgenden Schritte beinhaltet:

○ Platzieren von Mitteln (102) zum Erzeugen einer künstlichen Singularität auf dem Kabel;
○ Injizieren eines elektrischen Prüfsignals an einem Punkt (103) des Kabels;
○ Erfassen des Signals, das an den Singularitäten reflektiert wird, die das Kabel umfasst, um ein erstes Reflektogramm zu erzeugen;
○ Messen, an dem Reflektogramm, der zeitlichen Position $\Delta t$ der Spitze (202) des von seiner Reflexion an der künstlichen Singularität kommenden Signals;
○ Ermitteln der Ausbreitungsgeschwindigkeit $v_p$ = $2x/\Delta t$ des Signals in dem Kabel auf der Basis der zeitlichen Position $\Delta t$ und der Position x der Mittel (102) zum Erzeugen einer künstlichen Singularität an dem Kabel.

2. Messverfahren nach Anspruch 1, **dadurch gekennzeichnet, dass** die zeitliche Position $\Delta t$ in Bezug auf die erste zeitliche Spitze des Reflektogramms gemessen wird und die Position x in Bezug auf den Injektionspunkt (103) gemessen wird.

3. Messverfahren nach Anspruch 1, **dadurch gekennzeichnet, dass** es ferner die folgenden Schritte beinhaltet:

○ Versetzen der Mittel (102) zum Erzeugen einer künstlichen Singularität um eine Distanz d auf dem Kabel;
○ Durchführen einer zweiten Injektion des elektrischen Prüfsignals an dem Injektionspunkt (103);
○ Erfassen des an den Singularitäten, die das Kabel umfassen, reflektierten Signals, um ein zweites Reflektogramm zu erzeugen;
○ Subtrahieren des ersten und zweiten Reflektogramms, um ein drittes Reflektogramm zu erzeugen;
wobei die zeitliche Position $\Delta t$ zwischen den höchsten beiden Amplitudenspitzen des dritten Reflektogramms und der Position x als gleich d genommen wird.

4. Messverfahren nach einem der vorherigen Ansprüche, **dadurch gekennzeichnet, dass** die Mittel (102) zum Erzeugen einer künstlichen Singularität von wenigstens einem der folgenden Elemente gebildet werden: einem Metallring, einem ferromagnetischen Ring, einer Kabelhalterinne oder einem in Längsrichtung abwechselnd durch Metall und Isolierung gebildeten Ring.

5. Messverfahren nach einem der vorherigen Ansprüche, **dadurch gekennzeichnet, dass** die Reflektogramme von einem Algorithmus zum Verbessern des Signal-Rausch-Verhältnisses verarbeitet werden.

6. Messverfahren nach einem der vorherigen Ansprüche, **dadurch gekennzeichnet, dass** es ferner einen Schritt des Messens der Länge des Kabels auf der Basis der Ausbreitungsgeschwindigkeitsmessung $v_p$ und der Verzögerung $\Delta t'$ zwischen der ersten (201) und der letzten (203) Signalspitze des ersten Reflektogramms beinhaltet.

7. Messverfahren nach einem der vorherigen Ansprüche, **dadurch gekennzeichnet, dass** das injizierte Prüfsignal ein zeitlicher Impuls oder ein Signal mit regulierter Spektralmaske ist.

8. Messverfahren nach einem der Ansprüche 1 bis 7, **dadurch gekennzeichnet, dass** es ferner einen Schritt des Messens der Dämpfung $\alpha$ des Signals durch das Kabel mit der Beziehung $\alpha = \dfrac{-20\log\frac{\Gamma'}{\sqrt{1-\Gamma^2}}}{}$ beinhaltet, wobei $\Gamma$ die Amplitude der ersten Spitze des ersten Reflektogramms in Verbindung mit dem Injektionspunkt des Signals und $\Gamma'$ die Amplitude der letzten Spitze des mit dem Ende des Kabels assoziierten ersten Reflektogramms ist.

9. Vorrichtung zum Messen der physikalischen Eigenschaften eines Kabels (301), die wenigstens eine Vorrichtung (303) zum Injizieren eines Prüfsignals, eine Vorrichtung (303) zum Erfassen des an den Singularitäten des Kabels reflektierten Prüfsignals, Mittel (102) zum Erzeugen einer auf dem Kabel platzierten künstlichen Singularität und eine Vorrichtung (304) zum Nachverarbeiten des reflektierten Signals umfasst, wobei die Messvorrichtung zum Implementieren der Schritte des Verfahrens nach einem der Ansprüche 1 bis 8 ausgelegt ist.

10. Messvorrichtung nach Anspruch 9, **dadurch gekennzeichnet, dass** die Injektionsvorrichtung und die Erfassungsvorrichtung gemeinsam von einem Wellenformgenerator oder einem Oszilloskop oder einem Vektornetzanalysator oder einer elektronischen Karte erzeugt werden.

**Claims**

1. A method for measuring the physical characteristics of a cable (101), **characterised in that** it comprises at least the following steps:

   ○ placing means (102) for creating an artificial singularity onto said cable;
   ○ injecting an electrical test signal at a point (103) of said cable;
   ○ acquiring said signal reflected on the singularities that comprise said cable so as to produce a first reflectogram;
   ○ measuring, on said reflectogram, the time position $\Delta t$ of the peak (202) of the signal coming from its reflection on said artificial singularity;
   ○ determining the propagation speed $v_p = 2x/\Delta t$ of the signal in said cable on the basis of the time position $\Delta t$ and of the position x of said means (102) for creating an artificial singularity on said cable.

2. The measurement method according to claim 1, **characterised in that** said time position $\Delta t$ is measured in relation to the first time peak of the reflectogram and the position x is measured in relation to the injection point (103).

3. The measurement method according to claim 1, **characterised in that** it further comprises the following steps:

   ○ offsetting said means (102) for creating an artificial singularity by a distance d on said cable;
   ○ carrying out a second injection of said electrical test signal at said injection point (103);
   ○ acquiring said signal reflected on the singularities that comprise said cable so as to produce a second reflectogram;
   ○ subtracting said first and second reflectograms so as to produce a third reflectogram, with the time position $\Delta t$ being measured between the highest two amplitude peaks of the third reflectogram and the position x being taken as equal to d.

4. The measurement method according to any one of the preceding claims, **characterised in that** said means (102) for creating an artificial singularity are at least formed from one of the following elements: a metal ring, a ferromagnetic loop, a cable retention tray or a ring formed, in the longitudinal direction, by alternating metal and insulation.

5. The measurement method according to any one of the preceding claims, **characterised in that** said reflectograms are processed by an algorithm for enhancing the signal-to-noise ratio.

6. The measurement method according to any one of the preceding claims, **characterised in that** it further comprises a step of measuring the length of the cable on the basis of the propagation speed measurement $v_p$ and of the delay $\Delta t'$ between the first (201) and the last (203) signal peak of the first reflectogram.

7. The measurement method according to any one of the preceding claims, **characterised in that** said injected test signal is a time pulse or a signal with a controlled spectral mask.

8. The measurement method according to any one of claims 1 to 7, **characterised in that** it further comprises a step of measuring the attenuation $\alpha$ of the signal through the cable using the following relation $\alpha = \dfrac{-20\log\frac{\Gamma'}{\sqrt{1-\Gamma^2}}}{}$, with $\Gamma$ being the amplitude of the first peak of the first reflectogram, associated with the injection point of the signal, and $\Gamma'$ being the am-

plitude of the last peak of the first reflectogram associated with the end of the cable.

9. A device for measuring the physical characteristics of a cable (301), comprising at least one device (303) for injecting a test signal, one device (303) for acquiring the test signal reflected on the singularities of the cable, means (102) for creating an artificial singularity placed onto said cable and one device (304) for post-processing said reflected signal, said measurement device being designed to implement the steps of the method according to any one of claims 1 to 8.

10. The measurement device according to claim 9, **characterised in that** said injection device and said acquisition device are jointly produced by a waveform generator or an oscilloscope or a vector network analyser or an electronic board.

FIG.1

FIG.2

FIG.3

FIG.4

FIG.5

FIG.6

FIG.7

**EP 2 614 379 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20100045968 A
- US 3991364 A

- DE 947497 C